# EUROPEAN PATENT SPECIFICATION

(11) **EP 0 779 708 B1**
(45) Date of publication and mention of the grant of the patent: **14.05.2003**
(21) Application number: 96119808.2
(22) Date of filing: 10.12.1996
(51) Int. Cl.: H03H 9/02

(54) **Surface acoustic wave apparatus**
Akustische Oberflächenwellenvorrichtung
Dispositif à ondes acoustiques de surface

(30) Priority: 14.12.1995 JP 32542395
(43) Date of publication of application: 18.06.1997
(73) Proprietor: MURATA MANUFACTURING CO., LTD., Nagaokakyo-shi Kyoto-fu 226 (JP)
(72) Inventor: Ikada, Katsuhiro, Nagaokakyo-shi, Kyoto-fu (JP); Ogawa, Keiji, Nagaokakyo-shi, Kyoto-fu (JP); Ushiroku, Tadamasa, Nagaokakyo-shi, Kyoto-fu (JP)
(74) Representative: Zinnecker, Armin, Dipl.-Ing.

(56) References cited:
- EP-A- 0 638 953
- US-A- 4 758 922
- VISSER J H ET AL: "SURFACE ACOUSTIC WAVE FILTERS IN ZNO-SIO2-SI LAYERED STRUCTURES" PROCEEDINGS OF THE ULTRASONICS SYMPOSIUM, MONTREAL, OCT. 3 - 6, 1989, vol. 2, 3 October 1989, MCAVOY B R, pages 195-200, XP000139460

## Description

### BACKGROUND OF THE INVENTION

### 1. Field of the Invention

The present invention relates to a surface acoustic wave apparatus using a laminated ceramic substrate as a packaging member, and more particularly, to a surface acoustic wave apparatus comprising a surface acoustic wave device and a phase unit electrically connected to said surface acoustic wave device.

### 2. Description of the Related Art

Surface acoustic wave devices have been widely used in various fields such as the mobile communication field. In an actual component which includes a surface acoustic wave device, the device is accommodated in a hermetically sealed case made of metal or a package using a laminated ceramic substrate.

As electronic units have become more compact, it is required that circuits or apparatuses using surface acoustic wave devices also become more compact. In a mixed integrated circuit including a surface acoustic wave device and a semiconductor device, an attempt has been made to reduce the size of the circuit by using a multi-layer circuit substrate as a packaging member, as in Japanese Utility Model Application No. 2-8145.

The foregoing utility model application discloses a mixed integrated circuit in which a multi-layer circuit substrate provided with an electronic circuit disposed therein is used as a packaging member for packaging either a semiconductor device or a surface acoustic wave device or both, and the semiconductor or surface acoustic wave device is electrically connected to the electronic circuit.

Since the mixed integrated circuit uses the multi-layer circuit substrate including the electronic circuit as a packaging member, what was conventionally only a packaging member now contains the electronic circuit with electronic devices such as resistors and capacitors. Therefore, an electronic unit with such a mixed integrated circuit can presumably be constructed to be compact and lightweight.

A laminated ceramic substrate used as a packaging member in a surface acoustic wave device is made from an insulating Al₂O₃ ceramic to achieve reliability and low cost.

In some cases, when impedance matching is required, a phase unit is disposed at the input and output ends of a surface acoustic wave device. In this case, an impedance-matching phase unit is conventionally connected to an exterior surface of a surface acoustic wave apparatus which contains a surface acoustic wave device therein.

When a phase unit is disposed in a laminated ceramic substrate serving as a packaging member constituting a surface acoustic wave apparatus, the apparatus can be made compact. However, the inventors of the present application have discovered that the thickness of the surface acoustic wave apparatus increases and the characteristics of the apparatus deteriorate when the phase unit is disposed within the laminated ceramic substrate in the apparatus.

When a phase unit is disposed in a ceramic substrate with a signal line and ground electrodes being formed separately between different ceramic layers, the characteristic impedance of the phase unit is determined by the dielectric constant of the ceramic used, the width of the signal line, and the distances between the signal line and the ground electrodes. The laminated ceramic substrate serving as a packaging member in the surface acoustic wave apparatus is usually made from high purity alumina and its relative dielectric constant is about 10.

When a phase unit is disposed in a ceramic substrate made from alumina having a relative dielectric constant as high as about 10, the thickness of a section corresponding to the phase unit increases and a line length corresponding to the delay time is required. Therefore, when a phase unit is disposed in a laminated ceramic substrate made from the above-described alumina, the substrate is thicker than when the laminated ceramic substrate serves just as a packaging member in a surface acoustic wave device, and the surface acoustic wave apparatus is prevented from having a low profile.

To make the laminated ceramic substrate thinner, the width of the signal line in the phase unit needs to be reduced. In this case, the resistance of the signal line increases and a large insertion loss occurs. As a result, the characteristics of the surface acoustic wave apparatus deteriorate.

### SUMMARY OF THE INVENTION

The invention seeks to provide a surface acoustic wave apparatus of the above mentioned kind which can overcome the problems described above.

In accordance with the invention, this object is accomplished in a surface acoustic wave apparatus of the above kind that the surface acoustic wave apparatus further comprises a substrate made from a dielectric ceramic, the surface acoustic wave device is disposed on said substrate, the phase unit is disposed within said substrate and includes a signal line, first and second ground electrodes are disposed above and below said signal line respectively within said substrate, and an area of each said first and second ground electrodes is larger than an area of said signal line.

A surface acoustic wave apparatus in accordance with the invention has a number of advantages. Since the surface acoustic wave device is mounted on the substrate, the substrate can be served as a packaging member for a surface acoustic apparatus. Since the phase unit is built within the substrate which functions as a packaging member, the surface acoustic apparatus can be made compact. This compact, phase-unit-built-in surface acoustic wave apparatus is not susceptible to the effects caused by peripheral circuits when mounted.

Another surface acoustic wave apparatus in accordance with the invention further comprises a plurality of said acoustic wave devices, a plurality of phase units electrically connected to each surface acoustic wave device respectively for matching the impedance of each surface acoustic wave device, each of the plurality of phase unit are arranged at different positions with each other, and the second ground electrode of one of the phase units and the first ground electrode of the other of said phase units disposed right below the one of said phase units define a common ground electrode.

Since a plurality of said acoustic wave devices is mounted on the same substrate, the surface acoustic apparatus has a compact construction substantially when a plurality of said acoustic wave devices are used. And, since the second ground electrode of one of the phase units is used as the first ground electrode of the other of said phase units disposed right below the one of the phase units, the number of the ground electrodes is reduced, thereby the cost is reduced and the package is further reduced in height.

In another surface acoustic wave apparatus in accordance with the invention, distances between the first and the second electrodes of each plurality of phase units are different from each other.

When the width of the signal line is reduced to a minimum amount, which is specified by machining precision, a portion constituting a plurality of phase units in a case in which a plurality of phase units have different characteristic impedances and are formed in the direction of lamination can be made to have a minimum height by varying the distances between the ground electrodes of said plurality of phase units. And, a plurality of phase units which have different characteristic impedances each other are easily formed by varying the distance of the ground electrodes of each phase unit.

In another surface acoustic wave apparatus in accordance with the invention, the substrate comprises a plurality of layers. Each phase unit can be defined by the different layers, respectively. The substrate can be formed as a laminated structured substrate, and it makes easier to provide the acoustic wave apparatus having a complicated structure.

In another surface acoustic wave apparatus in accordance with the invention, a portion of said substrate where said phase unit is disposed has a relative dielectric constant of 7 or less.

Since a portion of said substrate where said phase unit is disposed has a relative dielectric constant of 7 or less, a portion constituting the phase unit can be made thinner than in a laminated ceramic substrate made from alumina, and an increase in insertion loss can be prevented. Therefore, an increase of insertion loss in the entire surface acoustic apparatus can be suppressed and at the same time the height thereof can be substantially reduced.

On the other hand, when a phase unit has the same thickness as a conventional phase unit, the width of a signal line can be increased. The electrical resistance caused by the signal line is thereby reduced and therefore the insertion loss decreases.

It should be noted that the same effect is obtained when the other portion of the substrate also has a relative dielectric constant of 7 or less.

In another present invention, the substrate is made from a dielectric ceramic having a relative dielectric constant of about 7 or less. The dielectric ceramic is not limited to any particular types. It is preferred that the laminated ceramic substrate be made from a BaO-SiO₂-Al₂O₃ dielectric material disclosed in the Japanese Examined Patent Publication 6-76253. In other words, the BaO-SiO₂-Al₂O₃ dielectric material preferably includes about 25 to about 80 weight percentage of the Si component in terms of SiO₂, about 15 to about 70 weight percentage of the Ba component in terms of BaO, about 1.5 to about 5 weight percentage of the B component in terms B₂O₃, about 1 to about 30 weight percentage of the Al component in terms of Al₂O₃, and more than about 0 to about 30 weight percentage of the Ca component in terms of CaO. A dielectric ceramic having a relative dielectric constant of about 6 to about 6.3 is then obtained.

It is also possible that the substrate be made from a MgO-SiO₂-Al₂O₃ dielectric material disclosed in Japanese Examined Patent Publication No. 6-2619. More specifically, the MgO-SiO₂₋Al₂O₃ dielectric material is a composition made by adding about 0.01 to about 5 weight percentage of silver or a silver compound in terms of metal silver to a composition including about 60 to about 90 weight percentage of cordierite, about 5 to about 20 weight percentage of B₂O₃, and about 1 to about 25 weight percentage of one or more of CaO, SrO, and BaO. A dielectric ceramic having a relative dielectric constant of about 6 to about 7 is then obtained.

These and other elements, features, and advantages of the preferred embodiments of the present invention will be apparent from the following detailed description of the preferred embodiments of the present invention, as illustrated in the accompanying drawings.

### BRIEF DESCRIPTION OF THE DRAWINGS

Fig. 1 is a cross section of a surface acoustic wave apparatus according to a first preferred embodiment of the present invention.

Figs. 2A to 2C are plan views illustrating a structure of a phase unit disposed in a laminated ceramic substrate used in the first preferred embodiment.

Figs. 3A to 3C are impedance Smith charts at the input and output terminals of the surface acoustic wave apparatus of the first preferred embodiment. Fig. 3A is an impedance Smith chart at the terminal located at the side to which a phase unit is connected. Fig. 3B is an impedance Smith chart at the terminal located at the side opposite the side to which a phase unit is connected. Fig. 3C is an impedance Smith chart in a case in which a phase unit is not connected.

Fig. 4 is a graph indicating the relationship between a relative dielectric constant and a distance h between ground electrodes in a phase unit in a case in which the phase unit having a characteristic impedance of 50W is made from various ceramic materials.

Fig. 5 is a cross section of a surface acoustic wave apparatus according to a second preferred embodiment of the present invention.

Figs. 6A to 6C are plan views illustrating a structure of a phase unit formed in a laminated ceramic substrate used in the second preferred embodiment of the present invention.

Fig. 7 is a cross section of a surface acoustic wave apparatus according to a third preferred embodiment of the present invention.

Figs. 8A to 8E are plan views illustrating a structure of phase units formed in a laminated ceramic substrate used in the third preferred embodiment of the present invention.

Fig. 9 is a cross section of a surface acoustic wave apparatus according to a fourth preferred embodiment of the present invention.

Figs. 10A to 10E are plan views illustrating a structure of phase units formed in a laminated ceramic substrate used in the fourth preferred embodiment of the present invention.

### DETAILED DESCRIPTION OF PREFERRED EMBODIMENTS

### First Preferred embodiment

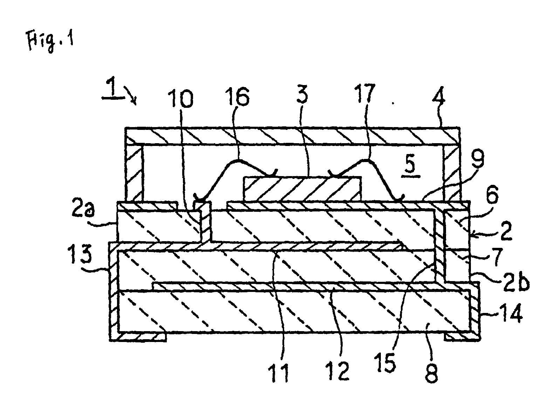

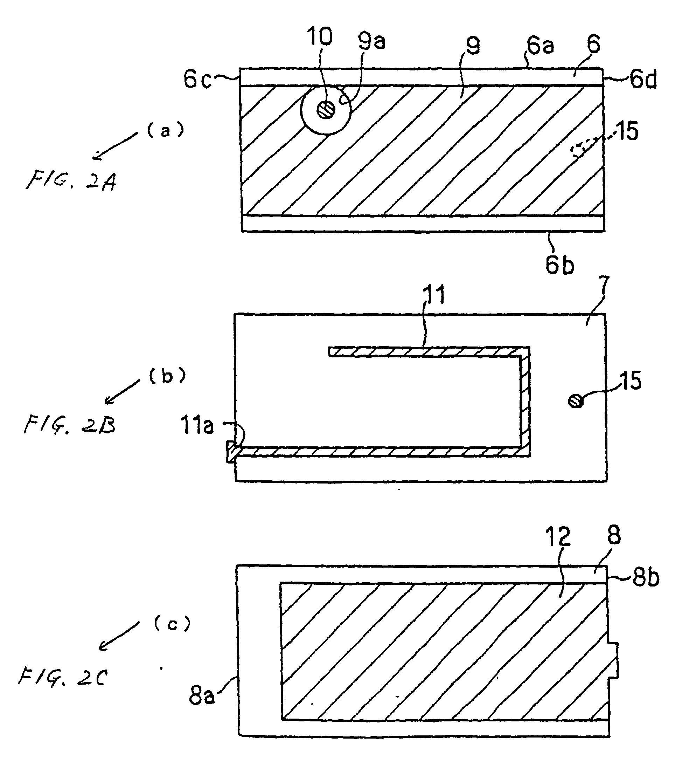

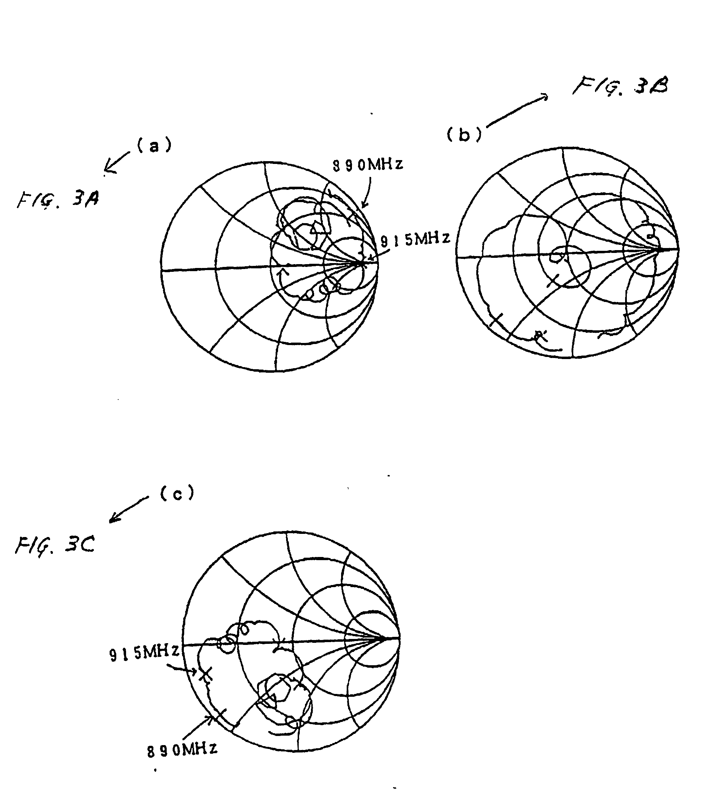

Fig. 1 is a typical cross section of a surface acoustic apparatus according to a first preferred embodiment of the present invention. In Fig. 1, there is shown a surface acoustic wave apparatus 1. The shapes and the positions of a signal line, ground electrodes, and through-hole electrodes disposed in a laminated ceramic substrate and to be described later are not necessarily shown exactly or to scale. In other words, to clarify the heights and the connections of these electrodes, the surface shapes of these electrodes are roughly, not precisely, shown in Fig. 1. The shapes and the positions of these electrodes are determined by plane shapes shown in Figs. 2A, 2B, and 2C.

The surface acoustic wave apparatus 1 includes a laminated ceramic substrate 2, a surface acoustic wave device 3 disposed on the laminated ceramic substrate 2, and a packaging member 4 for defining a package together with the laminated ceramic substrate 2. The packaging member 4 is secured on the laminated ceramic substrate 2, and the laminated ceramic substrate 2 and the packaging member 4 are arranged to define a space 5 for accommodating the surface acoustic wave device 3.

The surface acoustic wave device 3 is not limited to any specific type, and can comprise a transverse SAW filter, a SAW resonant filter, and a SAW resonator or other surface acoustic wave device selected according to a particular desired usage.

The packaging member 4 is not limited to any specific type either, and can be an appropriate packaging member made from materials such as a metal and a ceramic material including alumina and the material used for the laminated ceramic substrate 2 as long as it can define the accommodation space 5.

The present preferred embodiment features a ceramic used for the laminated ceramic substrate 2 and a phase unit built in the laminated ceramic substrate 2. The laminated ceramic substrate 2 is preferably made from a low-permittivity dielectric ceramic having a relative dielectric constant of about 7 or less. The above-described dielectric ceramic can be used as a low-permittivity dielectric ceramic member.

A preferred structure of the phase unit will be described below by referring to Fig. 2. The laminated ceramic substrate 2 has a configuration in which ceramic layers 6 to 8 are laminated preferably in order from the top to the bottom.

On the ceramic layer 6, a first ground electrode 9 is formed as shown in Fig. 2A. The first ground electrode 9 is formed such that it extends between both end edges 6c and 6d and the width of the electrode is preferably relatively wide, but it does not extend to the side edges 6a and 6b. There exists an electrode-less area 9a within the first ground electrode 9. A through-hole electrode 10 is located in the electrode-less area 9a. The through-hole electrode 10 passes through the ceramic layer 6 and is connected to a signal tine 11 disposed below.

The signal line 11 is formed on the upper surface of the ceramic layer 7. As clearly understood from Fig. 2B, the signal line 11 is formed to have an approximate U shape such that it has a sufficient line length without extending the plane shape of the ceramic layer 7, that is, without extending the plane shape of the laminated ceramic substrate 2. One end 11a of the signal line 11 preferably extends to one end surface 2a of the laminated ceramic substrate 2.

On the upper surface of the ceramic layer 8, a second ground electrode 12 is formed as shown in Fig. 2C. The second ground electrode 12 extends from one end edge 8b of the ceramic layer 8 toward the other end edge 8a without reaching the end edge 8a. The second ground electrode 12 is formed such that it is relatively wider than the signal line 11 and has the same width as that of the first ground electrode 9.

As shown in Fig. 1, in the laminated ceramic substrate 2, an external electrode 13 is formed on one end surface 2a. The external electrode 13 is electrically connected to the signal line 11. On the other end surface 2b, an external electrode 14 is formed. The external electrode 14 is electrically connected to the second ground electrode 12. The first and second ground electrodes 9 and 12 are electrically connected by a through-hole electrode 15. The through-hole electrode 15 is formed such that it passes through the ceramic layers 6 and 7.

A phase unit is defined in the laminated ceramic substrate 2 by the signal line 11 and the first and second ground electrodes 9 and 12.

The surface acoustic wave device 3 and the phase unit are electrically connected by a bonding wire 16 and the through-hole electrode 10 shown in Fig. 1. An electrode connected to the ground level of the surface acoustic wave device 3 is electrically connected to the first ground electrode 9 by a bonding wire 17.

In the surface acoustic wave apparatus 1 of the present preferred embodiment, since the phase unit is built within the laminated ceramic substrate 2, an external phase unit is not required for impedance matching of the surface acoustic wave device 3. Therefore, a circuit including the surface acoustic wave device 3 has a compact construction.

Since the laminated ceramic substrate 2 is made from the dielectric material having a relative dielectric constant of about 7 of less, the distance between the ground electrodes 9 and 12 can be made shorter while the width of the signal line 11 is the same, compared with a case in which a phase unit is formed in a conventional laminated ceramic substrate made from alumina. Therefore, the package has a low profile while an increase in insertion loss is prevented. These advantages will be more specifically described below with an example.

Figs. 3A and 3B show impedance Smith charts at the input and output terminals of the surface acoustic wave apparatus 1 in which a phase unit having a characteristic impedance of 50Ω is formed in the laminated ceramic substrate 2. Fig. 3A shows the characteristics at a side to which a phase unit having a delay time of 0.3 ns is connected.

For comparison, Fig. 3C shows an impedance Smith chart at the input and output terminals in a case when the phase unit is not connected to the surface acoustic wave device.

As clearly understood from a comparison between the characteristics shown Figs. 3A and 3C, the impedance at the transmission band (935 MHz to 960 MHz) is smaller than that at a blocking band (890 MHz to 915 MHz), which has lower frequencies that the transmission band, in the characteristics shown in Fig. 3A.

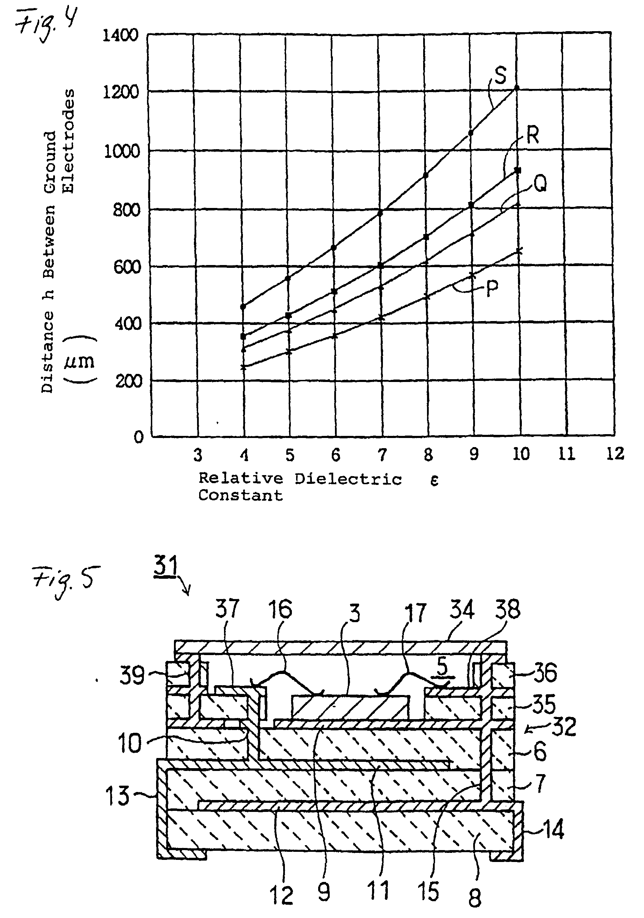

It has been determined that by constructing a phase unit within the interior of a laminated ceramic substrate 2 made from ceramic materials having various dielectric constants that the advantages of the preferred embodiments of the present invention are obtained with the use of a material having a relative dielectric constant of about 7 or less. The distance h between the first and second ground electrodes was measured in a case in which a phase unit having a characteristic impedance of 50Ω was built in a laminated ceramic substrate made from various ceramic materials with a signal line having a width of 100, 130, 150, or 200 µm being formed. Fig. 4 shows the results.

In Fig. 4, curve P indicates the result obtained when the width of a signal line was set to 100 µm, and curves Q, R, and S correspond to 130, 150, and 200 µm, respectively.

As clearly understood from Fig. 4, as compared with a case in which a highly pure alumina substrate having a relative dielectric constant of 10 is used, the distance h between the first and second ground electrodes is reduced by one third or more in a case when a phase unit of 50Ω is made in the laminated ceramic substrate made from a dielectric ceramic having a relative dielectric constant of about 7 or less. In other words, even if a phase unit having the same thickness is made, the width of a signal line can be extended by three µm or more in a case when a dielectric material having a relative dielectric constant of about 7 or less is used as compared with a case when an alumina substrate is used. When the width of a signal line is extended, the resistance thereof is reduced.

By using a low-permittivity ceramic to make a laminated ceramic substrate, even when a phase unit is disposed within the interior of the device, a compact, phase-unit-built-in surface acoustic wave apparatus which is not susceptible to effects caused by adjacent external circuits and components when mounted and in which an increase in insertion loss is prevented can be provided.

In the foregoing example, the characteristic impedance of the phase unit was set to 50Ω. The same advantage can be obtained when a phase unit having a characteristic impedance of another value is made.

### Second Preferred Embodiment

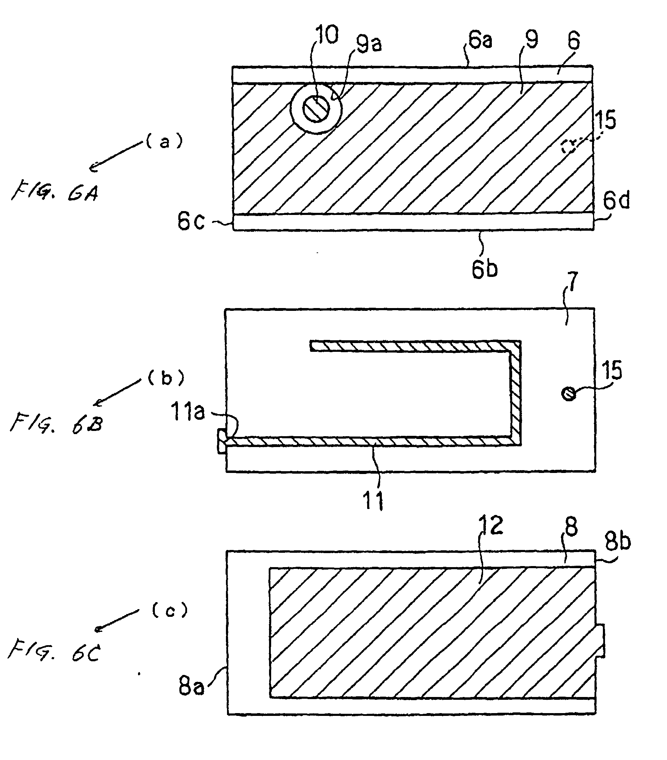

Fig. 5 is a typical cross section of a surface acoustic apparatus according to a second preferred embodiment of the present invention. Figs. 6A, 6B, and 6C are plans indicating an electrode system used for a phase unit formed in a laminated ceramic substrate. In Fig. 5, there is shown a surface acoustic wave apparatus 31. The shapes and the positions of a signal line, ground electrodes, and through-hole electrodes disposed in a multi-layer ceramic substrate 32 are shown roughly in order to clarify the heights and the connections thereof, in the same way as in Fig. 1, which shows the surface acoustic wave apparatus 1 of the first preferred embodiment. The shapes and the positions of these electrodes are determined by plane shapes shown in Figs. 6A, 6B, and 6C.

The surface acoustic wave apparatus 31 of the second preferred embodiment is preferably constructed in the same way as for the surface acoustic wave apparatus 1 of the first preferred embodiment except for the structure of a package formed by a laminated ceramic substrate and a packaging member. The same sections are represented by the same reference numerals and the descriptions thereof will be omitted.

In the surface acoustic wave apparatus 31, a laminated ceramic substrate 32 and a packaging member 34 define a package structure and a space 5 which is defined in the interior of the package accommodates a surface acoustic wave device 3.

The laminated ceramic substrate 32 is preferably the same as the laminated ceramic substrate 2 of the first preferred embodiment in terms of having a structure in which ceramic layers 6 to 8 are laminated. On the ceramic layer 6, however, substantially rectangular-frame-shaped ceramic layers 35 and 36 are preferably disposed in the present preferred embodiment. In other words, the substantially rectangular-frame-shaped ceramic layers 35 and 36 which have openings at the centers are preferably disposed on the ceramic layer 6 in order to form the accommodation space 5. The packaging member 34 is secured on the ceramic layer 36.

The ceramic layers 35 and 36 are preferably made from a dielectric ceramic having a relative dielectric constant of about 7 or less in the same way as for the ceramic layers 6 to 8. They may be made from a ceramic having a relative dielectric constant of more than about 7.

A through-hole electrode 15 is formed such that it passes through the ceramic layers 35 and 36 and extends to the upper surface of the ceramic layer 36. In the same way, a through-hole electrode 10 is formed such that it reaches the upper surface of the ceramic layer 35 and is electrically connected to an electrode pad 37 formed on the upper surface of the ceramic layer 35.

Bonding wire 16 is connected to the electrode pad 37. An electrode pad 38 is also formed on the upper surface of the ceramic layer 35 in order to electrically connect to the through-hole electrode 15. Bonding wire 17 is electrically connected to the electrode pad 38.

In addition, a through-hole electrode 39 is formed such that it is electrically connected to a first ground electrode 9 and it passes through the ceramic layers 35 and 36 to reach the upper surface of the ceramic layer 36.

Therefore, the through-hole electrode 39 and the through-hole electrode 15 are connected to the ground level and are also connected to the packaging member 34 on the upper surface of the ceramic layer 36. When the packaging member 34 is preferably made up of, for example, a metal plate, an electromagnetic shield is efficiently applied to the space 5. Not only a metal plate, but also a ceramic substrate or a synthetic resin plate coated with electrically conductive film at least at the lower surface may be used for the packaging member 34. When an electromagnetic shield is not required, the packaging member 34 may be made up of an appropriate, insulating ceramic plate such as an alumina plate, or a synthetic resin plate.

The surface acoustic wave apparatus 31 of the second preferred embodiment is configured in the same way as for the surface acoustic wave apparatus 1 of the first preferred embodiment except for the points described above. In other words, the multi-layer ceramic substrate 32 includes a signal line 11 and the first and second ground electrodes 9 and 12. This means that a phase unit is built in the multi-layer ceramic substrate 32. The ceramic layers 6 to 8 are preferably made from a dielectric ceramic having a relative dielectric constant of **about** 7 or less. Therefore, even when the phase unit is built in, an increase in insertion loss is avoided. A more compact, phase-unit-built-in surface acoustic wave apparatus which is not susceptible to effects of adjacent external circuits and components when mounted is provided.

### Third Preferred Embodiment

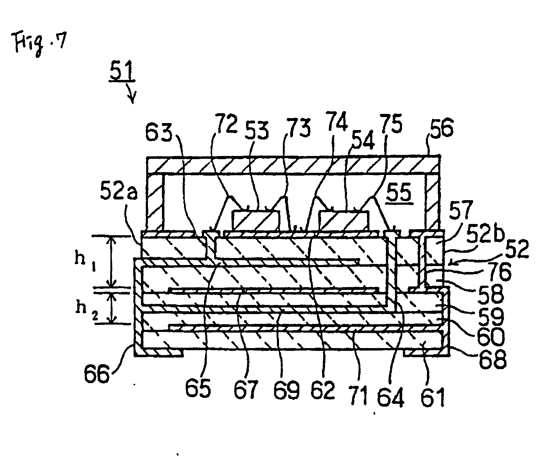

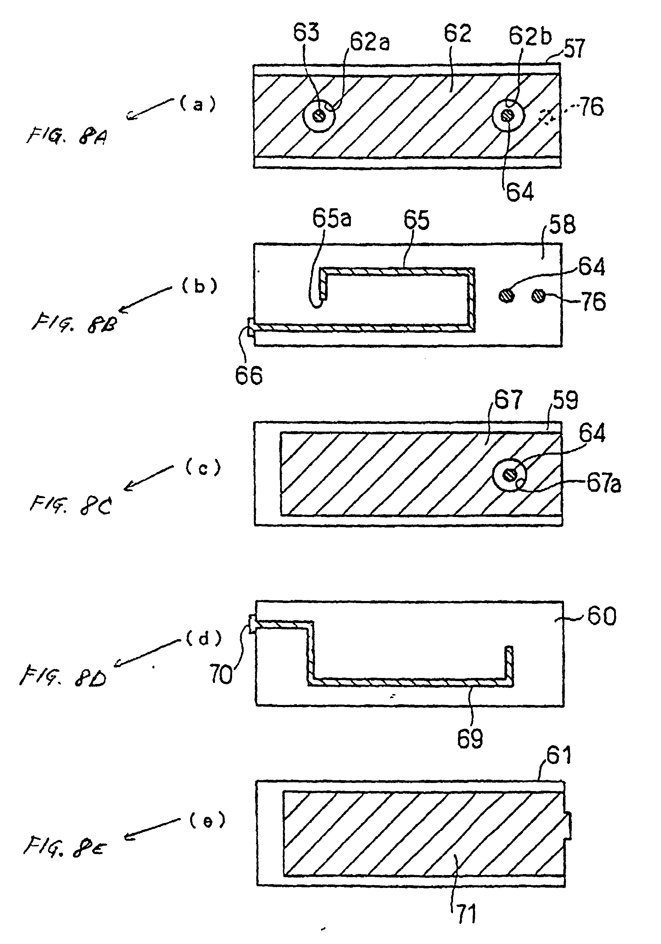

Fig. 7 is a typical cross section of a surface acoustic wave apparatus according to a third preferred embodiment of the present invention. Signal lines, ground electrodes, and through-hole electrodes to be described later and disposed in a laminated ceramic substrate 52 have plane shapes shown in Figs 8A to 8E, but are roughly shown in Fig. 7 to make the corresponding positions in height clear. In other words, the shapes and the positions of the signal lines, the ground electrodes, and the through-hole electrodes are not precisely shown in Fig. 7. They actually have cross-sectional structures corresponding to the structures shown in Figs. 8A to 8E.

A surface acoustic wave apparatus 51 is configured such that two surface acoustic wave devices 53 and 54 are disposed on the laminated ceramic substrate 52. On the laminated ceramic substrate 52, a packaging member 56 is also secured in order to define an accommodation space 55.

In this preferred embodiment, the multi-layer ceramic substrate 52 preferably includes two phase units having different distances between ground electrodes. By referring to Figs. 8A to 8E, the preferred embodiment will be described in detail below.

The multi-layer ceramic substrate 52 is preferably made from a dielectric material having a relative dielectric constant of about 7 or less and has a structure in which ceramic layers 57 to 61 are laminated in order from the top to the bottom.

On the upper surface of the ceramic layer 57, a first ground electrode 62 is formed as shown in Fig. 8A. Electrode-less areas 62a and 62b are provided within the first ground electrode 62. Through-hole electrodes 63 and 64 passing through the ceramic layer 57 are formed in the electrode-less areas 62a and 62b, respectively. Through-hole electrode 64 further passes through the ceramic layers 58 and 59 to extend downwardly and is electrically connected to a signal line 69 to be described later. The first ground electrode 62 is formed such that it does not extend to both side edges of the ceramic layer 57 but has a width **and** a shape **such that it** almost **extends to** the side edges, and it extends to both end edges 52a and 52b of the multi-layer ceramic substrate 52.

As shown in Fig. 8B, a signal line 65 is formed on the ceramic layer 58 with a thinner line than that of the ground electrode 62. As clearly understood from Fig. 8B, the signal line 65 has a curved shape in which a part of a substantially rectangular frame is missing, thereby the signal line 65 has a sufficient length without extending the plane shape of the ceramic layer 58.

In the vicinity of an inner end 65a of the signal line 65, the through-hole electrode 63 is electrically connected to the signal line 65. The other end of the signal line 65 extends to an end surface 52a of the laminated ceramic substrate 52 and electrically connected to an external electrode 66. The external electrode 66 is formed on an end surface 52a of the laminated ceramic substrate 52 and extends to the lower surface of the laminated ceramic substrate 52.

A common ground electrode 67 is formed on the upper surface of the ceramic layer 59 as shown in Fig. 8C. The common ground electrode 67 is formed such that it has the same width as the first ground electrode 62 and it does not extend to an end surface 52a of the laminated ceramic substrate 52. The common ground electrode 67 extends to an end surface 52b only and is electrically connected to an external electrode 68 shown in Fig. 7. The common ground electrode 67 may extend to an end surface 52a unless it touches the signal line. The external electrode 68 is formed such that it extends from an end surface to the lower surface of the laminated ceramic substrate 52 in the same way as the external electrode 66.

The first ground electrode 62 is connected to the common ground electrode 67 by the through-hole electrode 76 passing through the ceramic layers 57 and 58.

The common ground electrode 67 has an electrode-less area 67a. At the electrode-less area 67a, the through-hole electrode 64 described above passes through in a downward direction.

As shown in Fig. 8D, a signal line 69 is formed on the upper surface of the ceramic layer 60. The signal line 69 is formed by a narrow line-shaped electrode such that it has a smaller area than the common ground electrode 67. Since the signal line 69 has an approximate U shape, it has a sufficient length without extending the plane shape of the ceramic layer 64.

The through-hole electrode 64 is electrically connected to an inner end of the signal line 69. The other end of the signal line 69 extends to an end surface 52a of the laminated ceramic substrate 52 and electrically connected to an external electrode 70. The external electrode 70 is formed in a different area from that for the external electrode 66 on an end surface 52a.

A second ground electrode 71 is formed on the upper surface of the ceramic layer 61. The second ground electrode 71 extends from an end surface 52b toward an end surface 52a of the laminated ceramic substrate 52 but does not reach an end face 52a. The second ground electrode 71 has the same width as the common ground electrode 67. The second ground electrode 71 may extend to an end surtace 52a.

In the multi-layer ceramic substrate 52, two phase units are preferably formed in the vertical direction with the common ground electrode 67 used in by both phase units. One phase unit includes the signal line 65, the first ground electrode 62, and the common ground electrode 67, and the other phase unit includes the signal line 69, the common ground electrode 67, and the second ground electrode 71. Since the common ground electrode 67 is used in common as one of the ground electrodes of each of the upper and lower phase units, the multi-layer ceramic substrate 52 is made relatively thin despite the fact that two phase units are arranged in the vertical direction.

In addition, the ceramic layers 59 and 60 are preferably made thinner than the ceramic layers 57 and 58. Therefore, the distance h₁ between the ground electrodes (between the ground electrode 62 and the common ground electrode 67) in the upper phase unit is larger than the distance h₂ between the ground electrodes (between the common ground electrode 67 ad the second ground electrode 71) in the lower phase unit.

Since the distances h₁ and h₂ between the ground electrodes in the phase units disposed in the vertical direction differ, the two phase units have different characteristic impedances.

According to the present preferred embodiment, a plurality of phase units having different characteristic impedances are easily configured in the multi-layer ceramic substrate 52 by differentiating the ground-electrode distance of one phase unit from those of the other phase units. Therefore, according to the characteristics of a surface acoustic wave device used, a phase unit having the most suitable characteristic impedance can be readily constructed.

The surface acoustic wave device 53 secured on the multi-layer ceramic substrate 52 is electrically connected to the through-hole electrode 63, that is, to the phase unit disposed at the upper side, by a bonding wire 72. The surface acoustic wave device 54 is electrically connected to the through-hole electrode 64, that is, to the phase unit disposed at the lower side, by bonding wire 75. The surface acoustic wave devices 53 and 54 are electrically connected to the ground level by bonding wire 73 and 74, respectively.

Also in this preferred embodiment, since the phase units are disposed within the laminated ceramic substrate 52 as described above and the laminated ceramic substrate 52 is made from a dielectric ceramic having a relative dielectric constant of about 7 or less, a more compact, phase-unit-built-in surface acoustic wave apparatus which eliminates an increase in insertion loss and is not susceptible to effects of a adjacent electronic circuits and components when mounted is provided as in the first and second preferred embodiments.

### Fourth Preferred Embodiment

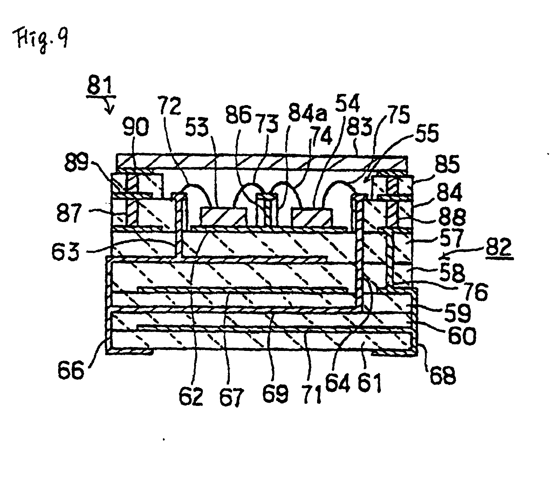

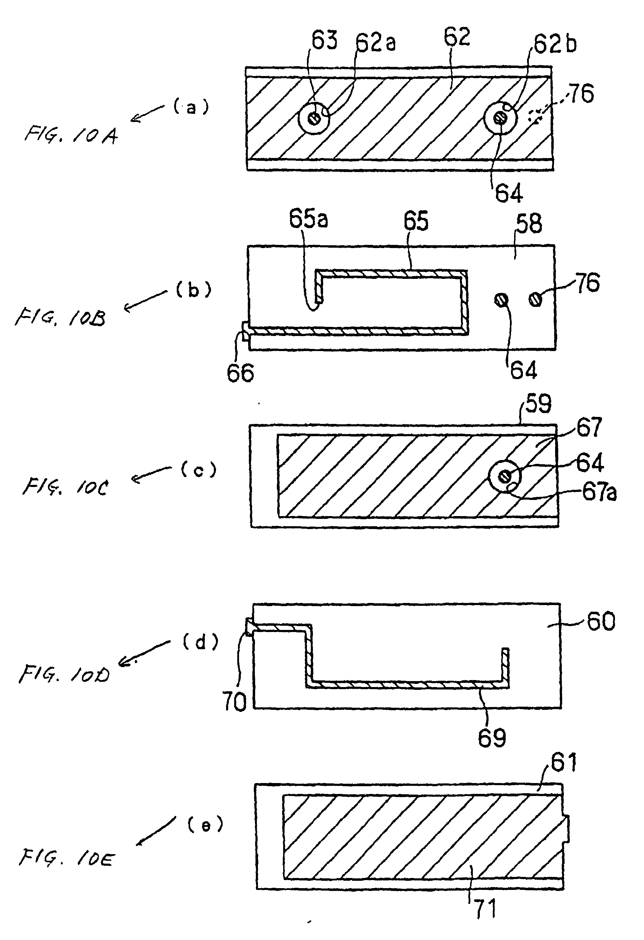

Fig. 9 is a typical cross section of a surface acoustic wave apparatus according to a fourth preferred embodiment of the present invention. Figs. 10A to 10E are plans illustrating electrode shapes on the upper surfaces of ceramic layers which constitute phase units in a laminated ceramic substrate used for the surface acoustic wave apparatus shown in Fig. 9.

Cross-sectional structures shown in Fig. 9 are roughly illustrated in order to facilitate the understanding of the positions and connections of signal lines, ground electrodes, and through-hole electrodes to be described later, as in Fig. 7. They are not necessarily shown precisely in Fig. 9. The plane shapes of the signal lines, the ground electrodes, and the through-hole electrodes are shown in Figs. 10A to 10E.

A surface acoustic wave apparatus 81 is configured in the same way as for the surface acoustic wave apparatus 51 of the third preferred embodiment except that a package structure formed by a laminated ceramic substrate and a packaging member is different. The same portions as those in the surface acoustic wave apparatus 51 of the third preferred embodiment are indicated by the same reference numerals, and the detailed descriptions thereof will be omitted.

In the surface acoustic wave apparatus 81, the package structure is formed by the laminated ceramic substrate 82 and the plane packaging member 83. In the accommodation space 55, two surface acoustic wave devices 53 and 54 are formed.

The laminated ceramic substrate 82 has a structure in which ceramic layers 57 to 61 are laminated. On the upper surfaces of the ceramic layers 57 to 61, ground electrodes, signal lines, and through-hole electrodes are formed as shown in Figs. 10A to 10E in the same way as for the surface acoustic wave apparatus 51 of the third preferred embodiment. The present preferred embodiment differs from the third preferred embodiment in that ceramic layers 84 and 85 are further formed above the ceramic layer 57.

The ceramic layer 84 has a substantially-rectangular-frame shape including two substantially rectangular openings at the center in plane. A surface acoustic wave device 53 is disposed in one opening and a surface acoustic wave device 54 is disposed in the other opening. The ceramic layer 85 has a substantially rectangular-frame shape including a large opening at the center in plane. The ceramic layers 84 and 85 may be made from the same ceramic material as the ceramic layers 57 to 61, or other ceramic material having a relative dielectric constant of about 7 or more.

Through-hole electrodes 63 and 64 extend to the upper surface of the ceramic layer 84 and are electrically connected to the surface acoustic wave devices 53 and 54 on the upper surface of the ceramic layer 84 by bonding wires 72 and 75, respectively. At a partitioning wall 84a disposed at the center of the ceramic layer 84, a through-hole electrode 86 passing through the ceramic layer 84 is formed. The through-hole electrode 86 is electrically connected to a first ground electrode 62, and also electrically connected to bonding wire 73 and 74.

Through-hole electrodes 87 and 88 are formed such that they penetrate the ceramic layers 84 and 85. The through-hole electrodes 87 and 88 are electrically connected to the substantially rectangular-frame-shaped shield electrodes 89 and 90 on the upper surfaces of the ceramic layers 84 and 85, and are also electrically connected to the first ground electrode 62 at their lower ends.

The packaging member 83 is preferably made up of a metal plate or an insulating plate of which the lower surface is covered with electrically conductive film, and is formed such that it electromagnetically shields an accommodation space 55. The packaging member 83 may be made up of a synthetic resin plate or an insulating ceramic plate.

Since the surface acoustic wave apparatus 81 of the fourth preferred embodiment is configured in the same way as for the surface acoustic wave apparatus 51 of the third preferred embodiment except that the above-described package structure is used, even when phase units are constructed within the package structure, an increase in insertion loss is prevented. The surface acoustic wave apparatus 81 serves as a more compact surface acoustic wave apparatus which has built-in phase units and is not susceptible to effects of a adjacent external circuits and electronic components when mounted. In addition, in the same way as for the third preferred embodiment, since the characteristic impedances of phase units disposed at the upper and lower positions can easily be changed, phase units best suited to the surface acoustic wave devices used can be readily configured.

## Claims

1. A surface acoustic wave apparatus(1), comprising:
a surface acoustic wave device(3), and
an impedance-matching phase unit electrically connected to said surface acoustic wave device(3), and
a substrate(2) made from a dielectric ceramic, wherein
said surface acoustic wave device(3) is disposed on said substrate(2),
said impedance-matching phase unit is disposed within said substrate(2) and includes a signal line(11),
first and second ground electrodes(9)(12) are disposed above and below said signal line(11) respectively within said substrate(2), and
an area of each said first and second ground electrodes(9)(12) is larger than an area of said signal line(11),

2. A surface acoustic wave apparatus(51) according to Claim 1, comprising
a plurality of acoustic wave devices(53)(54),
a plurality of impedance-matching phase units as defined in claim 1, each electrically connected to one of said surface acoustic wave device(53)(54), respectively, for matching the impedance of each said surface acoustic wave device(53)(54),
each of said plurality of impedance-matching phase unit being arranged at different positions with each other, and wherein the second ground electrode(67) of one of said impedance-matching phase units and the first ground electrode(67) of another of said impedance-matching phase units disposed right below said one of said phase units define a common ground electrode(67).

3. A surface acoustic wave apparatus(51) according to Claim 2, wherein
distances(h₁)(h₂) between the first and the second electrodes of each of said plurality of impedance-matching phase units are different from each other.

4. A surface acoustic wave apparatus(1)(51) according to one of Claims 1 to 3,
wherein
said substrate(2)(52) comprises a plurality of layers.

5. A surface acoustic wave apparatus(1)(51) according to one of Claims 1 to 4,
wherein
a portion of said substrate(2)(52) where each of said impedance-matching phase units is disposed has a relative dielectric constant of about 7 or less.

6. A surface acoustic wave apparatus(1)(51) according to one of Claims 1 to 5,
wherein said substrate or
said portion of substrate(2)(52) is made from a BaO-SiO₂-Al₂O₃ dielectric material.

7. A surface acoustic wave apparatus(1)(51) according to one of Claims 1 to 5,
wherein said substrate or
said portion of substrate(2)(52) is made from a MgO-SiO₂-Al₂O₃ dielectric material.

## Patentansprüche

1. Akustische Oberflächenwellenvorrichtung (1), umfassend:
eine akustische Oberflächenwellenanordnung (3), und
eine Widerstand abgleichende Phaseneinheit, die elektrisch mit der akustischen Oberflächenwellenanordnung (3) verbunden ist, und
ein Substrat (2), das aus dielektrischer Keramik hergestellt ist, wobei
die akustische Oberflächenwellenanordnung (3) auf dem Substrat (2) angeordnet ist und wobei
die Widerstand abgleichende Phaseneinheit innerhalb des Substrats (2) angeordnet ist und eine Signalleitung (11) umfasst, wobei die erste und die zweite Erdelektrode (9) (12) über beziehungsweise unter der Signalleitung (11) innerhalb des Substrats (2) angeordnet sind und
eine Flächenerstreckung jeder der ersten und zweiten Erdelektroden (9) (12) größer als eine Flächenerstreckung der Signalleitung (11) ist.

2. Akustische Oberflächenwellenvorrichtung (51) nach Anspruch 1, umfassend:
eine Mehrzahl akustischer Oberflächenwellenanordnungen (53) (54),
eine Mehrzahl von Widerstand abgleichenden Phaseneinheiten, wie in Anspruch 1 definiert, wobei jede mit jeweils einer der akustischen Oberflächenwellenanordnungen (53) (54) zum Abgleichen des Widerstands jeder akustischen Oberflächenwellenanordnung (53) (54) verbunden ist, wobei
jede der Mehrzahl von Widerstand abgleichenden Phaseneinheiten an zueinander unterschiedlichen Positionen angeordnet ist, wobei
die zweite Erdelektrode (67) einer der Widerstand abgleichenden Phaseneinheiten und die erste Erdelektrode (67) einer anderen der Widerstand abgleichenden Phaseneinheiten, die genau unter der einen der Phaseneinheiten angeordnet ist, eine gemeinsame Erdelektrode (67) definieren.

3. Akustische Oberflächenwellenvorrichtung (51) nach Anspruch 2, wobei die Abstände (h₁) (h₂) zwischen der ersten und der zweiten Erdelektrode jeder der Mehrzahl der Widerstand abgleichenden Phaseneinheiten von einander unterschiedlich sind.

4. Akustische Oberflächenwellenvorrichtung (1) (51) nach einem der Ansprüche 1 bis 3, wobei das Substrat (2) (52) eine Mehrzahl von Schichten umfasst.

5. Akustische Oberflächenwellenvorrichtung (1) (51) nach einem der Ansprüche 1 bis 4, wobei ein Abschnitt des Substrats (2) (52), wo jede der Widerstand abgleichenden Phaseneinheiten angeordnet ist, eine relative dielektrische Konstante von ungefähr 7 oder weniger aufweist.

6. Akustische Oberflächenwellenvorrichtung (1) (51) nach einem der Ansprüche 1 bis 5, wobei das Substrat oder der Abschnitt des Substrats (2) (52) aus einem BaO-SiO₂-Al₂O₃ dielektrischen Material hergestellt ist.

7. Akustische Oberflächenwellenvorrichtung (1) (51) nach einem der Ansprüche 1 bis 5, wobei das Substrat oder der Abschnitt des Substrats (2) (52) aus einem MgO-SiO₂-Al₂O₃ dielektrischen Material hergestellt ist.

## Revendications

1. Appareil à ondes acoustiques de surface (1) comprenant :
un dispositif à ondes acoustiques de surface (3) et
une unité de phase d'adaptation d'impédance reliée électriquement audit dispositif à ondes acoustiques de surface (3), et
un substrat (2) réalisé en une céramique diélectrique,
dans lequel ledit dispositif à ondes acoustiques de surface (3) est disposé sur ledit substrat (2),
ladite unité de phase d'adaptation d'impédance est disposée dans ledit substrat (2) et comprend une ligne de signal (11), des première et seconde électrodes de masse (9) (12) sont disposées au-dessus et au-dessous de ladite ligne de signal (11) respectivement à l'intérieur dudit substrat (2), et
une plage de chacune desdites première et seconde électrodes de masse (9) (12) est supérieure à une plage de ladite ligne de signal (11).

2. Appareil à ondes acoustiques de surface (51) selon la revendication 1, comprenant
une pluralité de dispositifs à ondes acoustiques (53) (54), une pluralité d'unités de phase d'adaptation d'impédance telles que définies dans la revendication 1 reliées chacune à l'un desdits dispositifs à ondes acoustiques de surface (53) (54), respectivement, pour adapter l'impédance de chacun desdits dispositifs à ondes acoustiques de surface (53) (54), chacune desdites unités de phases d'adaptation d'impédance étant disposée en des positions différentes les unes des autres, et dans lequel
la seconde électrode de masse (67) d'une desdites unités de phase d'adaptation d'impédance et la première électrode de masse (67) d'une autre desdites unités de phase d'adaptation d'impédance disposées juste au-dessous de ladite une desdites unités de phase définissent une électrode de masse commune (67).

3. Appareil à ondes acoustiques de surface (51) selon la revendication 2, dans lequel les distances (h₁) (h₂) entre les première et seconde électrodes de chacune de ladite pluralité d'unités de phase d'adaptation d'impédance sont différentes l'une de l'autre.

4. Appareil à ondes acoustiques de surface (1) (51) selon une des revendications 1 à 3, dans lequel ledit substrat (2) (52) comprend une pluralité de couches.

5. Appareil à ondes acoustiques de surface (1) (51) selon une des revendications 1 à 4, dans lequel une partie dudit substrat (2) (52) où chacune desdites unités de phase d'adaptation d'impédance est disposée possède une constante diélectrique relative d'environ 7 ou moins.

6. Appareil à ondes acoustiques de surface (1) (51) selon une des revendications 1 à 5, dans lequel ledit substrat ou ladite partie de substrat (2) (52) est réalisée en un matériau diélectrique BaO-SiO₂-Al₂O₃.

7. Appareil à ondes acoustiques de surface (1) (51) selon une des revendications 1 à 5, dans lequel ledit substrat ou ladite partie de substrat (2) (52) est réalisé en un matériau diélectrique MgO-SiO₂-Al₂O₃.
